# EUROPÄISCHE PATENTSCHRIFT

(11) **EP 2 548 419 B1**
(45) Veröffentlichungstag und Bekanntmachung des Hinweises auf die Patenterteilung: **24.02.2016**
(21) Anmeldenummer: 11708804.7
(22) Anmeldetag: 11.03.2011
(51) Int. Cl.: H05K 1/02, H05K 1/18, H05K 3/00, H05K 3/02, H01L 25/075, H01L 33/64

(54) **FOLIENSYSTEM FÜR LED-ANWENDUNGEN**
FILM SYSTEM FOR LED APPLICATIONS
SYSTÈME DE FEUILLES POUR DES APPLICATIONS DEL

(30) Priorität: 16.03.2010 DE 102010011604
(43) Veröffentlichungstag der Anmeldung: 23.01.2013
(73) Patentinhaber: Eppsteinfoils GmbH & Co Kg, 65817 Eppstein (DE)
(72) Erfinder: WAEGLI, Peter, CH-5620 Bremgarten (CH); REES, Markus, 65817 Eppstein (DE)
(74) Vertreter: Meyer-Dulheuer, Karl-Hermann
(86) Internationale Anmeldenummer: PCT/EP2011/053705
(87) Internationale Veröffentlichungsnummer: WO 2011/113762

(56) Entgegenhaltungen:
- DE-A1-102008 016 458
- DE-A1-102008 039 071
- US-A1- 2003 011 058

## Beschreibung

Die vorliegende Erfindung betrifft einen Verbund von Kunststoff- und Metallfolien, der für die Verschaltung und den Anschluss von Leuchtdioden (lichtemittierende Dioden, LEDs) eingesetzt werden kann. Hierfür wird eine flexible Leiterplatte bereitgestellt, auf welche mindestens eine Strahlungsquelle aufgebracht ist und welche aus einem Foliensystem besteht. Die flexible Leiterplatte weist eine thermische Verbindung zu einer Wärmesenke auf und das Foliensystem ist mindestens aus einer isolierenden Trägerschicht und einer Metallfolie zusammengesetzt. Die isolierende Trägerschicht ist an den Stellen, an denen die thermische Verbindung mit der Wärmesenke hergestellt wird, geöffnet und die Metallfolie ist in unterschiedliche Abschnitte unterteilt.

LEDs erfüllen mittlerweile bezüglich Lichtspektrum und Lichtausbeute zunehmend die Anforderungen, die an leistungsfähige Beleuchtungselemente gestellt werden. Im Vergleich zu herkömmlichen Beleuchtungselementen, wie Glühlampen, Halogenlampen und Leuchtstoffröhren, weisen LEDs eine Reihe von Vorteilen auf. Der Energieverbrauch ist bei gleicher Lichtmenge reduziert, es wird weniger Wärme erzeugt, LEDs sind unempfindlicher gegen Erschütterungen, erreichen deutlich kürzere Schaltzeiten und weisen eine höhere Lebendauer auf.

Aufgrund der geringen Baugröße weisen LEDs zudem Designvorteile bei der Ausgestaltung von Beleuchtungsmodulen auf, für Anwendungen in der allgemeinen Raumbeleuchtung, aber auch in der Industrie, der Automobiltechnik, sowie der medizinischen Gerätetechnik und anderen Anwendungen.

Um diese Vorteile in den genannten Anwendungen umsetzen zu können, sind spezielle Bauelemente für die Verschaltung einzelner LEDs zu größeren Beleuchtungsmodulen notwendig, welche idealerweise die folgenden Anforderungen erfüllen: Wünschenswert ist ein geringer elektrischer Widerstand für Ströme im Bereich von 100 mA bis zu einigen A und Spannungen von bis zu typischerweise 500 V. Es ist ebenfalls erwünscht, Beleuchtungselemente flexibel auf möglichst beliebige 3-dimensionale Strukturen aufzubringen, um eine Vielzahl an Beleuchtungseffekten erreichen zu können.

Das thermische Management ist aufgrund der hohen Leistungen auf sehr kleiner Fläche von wenigen mm² der LEDs extrem wichtig. Eine geringe Sperrschichttemperatur ist unerlässlich, weil eine erhöhte Sperrschichttemperatur eine Verminderung der Lebensdauer und Lichtleistung der LED zur Folge hat. Der Wirkungsgrad sinkt hierbei mit steigender Temperatur, so dass die Lichtausbeute an der Leistungsgrenze je nach Art der Kühlung absinkt. Aus diesem Grund ist es zentral, dass eine möglichst gute thermische Verbindung zu einer Wärmesenke hergestellt wird, so dass die Wärme, die in der LED entsteht, möglichst effizient abgeführt wird. Daher verfügen LEDs neben den beiden elektrischen (+/-) typischerweise über einen "Kühlungsanschluss", der unter dem Halbleiterübergang angeordnet ist, der für die Lichterzeugung zuständig ist und möglichst effizient an eine Wärmesenke angekoppelt werden muss, beispielsweise über einen thermisch leitenden Kleber oder ein Lot. Typischerweise muss dabei für eine Leistungsanwendung ein thermischer Widerstand von 0,5-2 K/W erreicht werden.

Für die Verschaltung von LEDs werden momentan sogenannte Hochleistungsleiterplatten verwendet, für welche typischerweise unterschiedliche Technologien zur Anwendung gelangen. Metallkernleiterplatten verfügen über einen Metallkern aus Kupfer oder Aluminium, der für die Abführung der Wärme zuständig ist. Aus der DE 10 2008 016 458 A1 ist beispielsweise eine starre Leiterplatte bekannt, die mit mindestens einem Durchgangsloch versehen ist, in dem ein Wärmeableitelement angeordnet ist, wobei mindestens eine Strahlungsquelle auf dem Wärmeableitelement angeordnet ist. Bei dem gut wärmeableitenden Wärmeableitelement handelt es sich beispielsweise um einen Block aus Metall, insbesondere Kupfer. Die Nachteile von diesen Leiterplatten sind die hohen Kosten pro Fläche, sowie Größe und Gewicht. Im Gegensatz dazu bestehen *"Direct Copper Bond"* (DCB)-Substrate aus Kupferleiterbahnen, die auf Keramiksubstrate aufgebracht sind. Diese finden primär Anwendung in der Leistungselektronik für Automobilanwendungen und teilweise in der Opto-Elektronik für den Anschluss von Lasermodulen. Aus der US 4,563,383 ist eine dreilagige Kupfer-Folie beschrieben, die zwischen zwei Keramikschichten eingebettet ist, welches die Herstellung von dünnen Modulen erlaubt. Die Nachteile aller starren Leiterplatten sind die Einschränkungen in der Designfreiheit, da es nicht möglich ist, verschiedene dreidimensionale Strukturen mit den starren Leiterplatten einzunehmen und ebenfalls eine gewisse Größe nicht unterschritten werden kann.

Aus diesem Grunde wurden flexible Leiterplatten, unter Anderem auf Basis von Polyimid-Folien, die eine hohe Temperaturbeständigkeit aufweisen, oder auch PET (Polyethylenterephthalat)- und PEN (Polyethylennaphthalat)-Folien, entwickelt. Aus dem Stand der Technik sind flexible Leiterplatten bekannt, die Polyimidfolien als Basismaterial verwenden, auf welche eine dünne Kupferschicht aufgebracht ist. Für dynamische Flexverbindungen kann Acrylkleber verwendet werden, Epoxidkleber erlaubt auch eine gewisse dynamische Flexibilität. Eine flexible Schutzfolie kann, ebenfalls unter der Verwendung eines Acryl- oder Epoxidklebers, aufgepresst werden. Die damit aufgebauten Flexschaltungen können platzsparend durch Falten in engste Strukturen, wie beispielsweise Fotoapparaten und Videokameras eingesetzt werden. Flexible Verbindungen werden ebenfalls für dauernde Beanspruchungen, wie in Tintenstrahldruckern oder in Laptops als Verbindung von Mainboard und Monitor eingesetzt. Der Nachteil von flexiblen Leiterplatten dieser Bauart ist, dass keine effiziente Wärmeableitung möglich ist. Zudem sind sie immer noch zu starr, um sie problemlos auf frei gestaltete dreidimensionale Substrate aufzubringen.

Um diese Problem zu umgehen, wurden verschiedene Techniken entwickelt. In der EP 1 874 101 A1 ist beispielsweise eine flexible Leiterplatte beschrieben, die aus alternierenden Schichten von Metallfolien und Kunststofffolien besteht, auf welche eine LED-Lichtquelle aufgebracht werden kann. Diese sind insbesondere für die Verwendung als LED-Lichtquelle für die Hintergrundbeleuchtung von Flüssigkristallbildschirmen geeignet. Diese Leiterplatten wiesen jedoch einen vielschichtigen und komplexen Aufbau auf, und verfügen über eine wenig effiziente Wärmeableitung aufgrund der geringen Schichtdicken. Zudem können sie nicht ohne zusätzlichen Montageaufwand mit dreidimensional ausgestatteten Substraten verbunden werden.

In der Offenlegungsschrift DE 10 2008 039 071 A1 wird eine Beleuchtungsvorrichtung für Fahrzeuge beschrieben mit einer mindestens ein LED-Element aufweisenden LED-Einheit enthaltend eine flexible Leiterplatte zur Aufnahme von elektrischen Bauelementen und ein mit der flexiblen Leiterplatte verbundenes starres Versteifungselement.

Somit war es eine Aufgabe der vorliegenden Erfindung, die bekannten Nachteile aus dem Stand der Technik zu überwinden und flexible Leiterplatten zur Verfügung zu stellen, die für die Verschaltung und den Anschluss von LEDs verwendet werden können, bei welchen eine effiziente Wärmeableitung erfolgt, ohne zugleich Einschränkungen im Hinblick auf Designfreiheit hinnehmen zu müssen. Zusätzlich sollen diese Leiterplatten einfach zu fertigen sein und möglichst niedrige Herstellungskosten aufweisen. Des Weiteren soll eine möglichst einfache Verbindung mit einem dreidimensional ausgestalteten Substrat möglich sein.

Die Aufgabe wird gelöst durch den erfindungsgemäßen Verbund von Kunststoff- und Metallfolien, der für die Verschaltung und den Anschluss von LEDs eingesetzt werden kann. Hierfür wird eine flexible Leiterplatte bereitgestellt, auf welche mindestens eine Strahlungsquelle aufgebracht ist und welche aus einem Foliensystem besteht. Die flexible Leiterplatte weist eine thermische Verbindung zu einer Wärmesenke auf und das Foliensystem ist mindestens aus einer isolierenden Trägerschicht und einer Metallfolie zusammengesetzt. Die isolierende Trägerschicht ist an den Stellen, an denen die thermische Verbindung mit der Wärmesenke hergestellt wird, geöffnet und die Metallfolie ist in unterschiedliche Abschnitte unterteilt. Die thermische Verbindung wird zwischen räumlich getrennten Abschnitten der Metallfolie und der Wärmesenke und zwischen räumlich getrennten Abschnitten der Metallfolie und der Strahlungsquelle ausgebildet. Die Metallfolie ist zudem in voneinander räumlich getrennte Abschnitte unterteilt, wobei mindestens ein Abschnitt eine elektrische Verbindung zur Strahlungsquelle/n ausbildet und mindestens ein weiterer Abschnitt eine elektrisch isolierte und/oder thermische Verbindung zur Strahlungsquelle und zur Wärmesenke ausbildet. Ein Teil der Metallfolie wird als elektrischen Leiter benutzt und ein davon räumlich abgetrennten Abschnitt wird für die Wärmeableitung von der Strahlungsquelle zur Wärmesenke verwendet.

Die isolierende Trägerschicht hat den Vorteil, dass diese auf eine beliebige dreidimensionale Struktur auflaminiert werden kann, und dann nach der Lamination haftend mit der Struktur verbunden ist. Die Struktur dient gleichzeitig als Wärmesenke. Die Trägerschicht muss an den Stellen, an denen eine thermische Verbindung zwischen der Metallschicht und der Wärmesenke hergestellt wird, geöffnet sein. Hierbei muss die isolierende Kunststoffschicht derart entfernt werden, dass keine störenden Reste auf der Metallschicht zurückbleiben.

Die Trägerfolie besteht vorzugsweise aus Polyimid, Polyvinylbutyral (PVB), Polyvinylfluorid, Ethylenvinylacetat (EVA) oder einem ähnlichen Kunststoff.

Die Metallfolie dient als elektrischer Leiter für den Anschluss und die Verschaltung. Die Metallfolie ist je nach Verschaltungsstruktur in verschiedene Bereiche unterteilt, vorzugsweise mittels Laser, so dass die benötigte Leiterbahnstruktur entsteht. Auf dieser Metallfolie wird die Strahlungsquelle, vorzugsweise eine oder mehrere LEDs und gegebenenfalls weitere periphere Schaltkreise aufgebracht und mit dieser verbunden. Aufgrund der Unterteilung der Metallfolie in unterschiedliche Abschnitte ist es möglich, einen Teil der Metallfolie als elektrischen Leiter zu benutzen und einen davon räumlich abgetrennten Abschnitt für die Wärmeableitung von der Strahlungsquelle zur Wärmesenke zu verwenden.

Die Erfindung hat gegenüber dem Stand der Technik einen erheblichen Vorteil, da das Substrat, auf welches das Foliensystem aufgebracht wird, gleichzeitig als Wärmesenke genutzt wird. Die Wärmesenke besteht vorzugsweise aus einem Material mit einem kleinem thermischen Widerstand (typ. <=2 K/W) und einer hohen Wärmekapazität (typ. > 350 J/(kg•K), besonders bevorzugt sind Metalle wie Aluminium, Kupfer, Stahl, oder Messing.

Die erfindungsgemäße flexible Leiterplatte weist gegenüber dem Stand der Technik eine Reihe von Vorteilen auf. Die Materialkosten sind durch die Verwendung von dünnen Folienschichten erheblich reduziert. Außerdem sind für eine Modulmontage weniger Arbeitsschritte notwendig, wobei es sich bei dem Auflaminieren um einen einfachen Montageschritt handelt. Ein weiterer Vorteil ist die erreichte Designfreiheit bezüglich der Realisierung unterschiedlichster dreidimensionaler Formen, welche bei starren Leiterplatten aufgrund der wärmeableitenden Metallkerne nicht möglich ist.

Bei der erfindungsgemäßen flexiblen Leiterplatte wird die thermische Verbindung zwischen räumlich getrennten Abschnitten der Metallfolie und der Wärmesenke und zwischen räumlich getrennten Abschnitten der Metallfolie und der Strahlungsquelle ausgebildet. Die thermische Verbindung wird vorzugsweise mittels eines thermisch leitenden Klebers oder Lot hergestellt. Die Benutzung von thermisch leitenden Klebern bringt einen zusätzlichen Vorteil, wenn die thermisch leitenden Verbindungen elektrisch isolierend sein sollen. Bei dem thermisch leitenden Kleber handelt es sich vorzugsweise um einen mit BorNitrid gefüllten Epoxidharz-Klebstoff.

Die Metallfolie ist erfindungsgemäß in voneinander räumlich getrennte Abschnitte unterteilt, wobei mindestens ein Abschnitt eine elektrische Verbindung zur Strahlungsquelle/n ausbildet, welche vorzugsweise mittels eines elektrisch leitenden Klebers oder Lot hergestellt wird und wobei mindestens ein weiterer Abschnitt eine elektrisch isolierte und/oder thermische Verbindung zur Strahlungsquelle und zur Wärmesenke ausbildet, welche vorzugsweise mittels eines thermisch leitenden Klebers oder Lot hergestellt wird.

In einer alternativen Ausgestaltungsform ist zwischen der Metallfolie und der Wärmesenke ebenfalls eine elektrische Verbindung, vorzugsweise mittels eines elektrisch leitenden Klebers oder Lot, ausgebildet. Diese Alternative ist von Bedeutung, wenn die Stromzuführung zu den Bauteilen (Strahlungsquelle(n) und/oder periphere Schaltkreise) über das Substrat erfolgt. Die Kontaktöffnungen sind dann typischerweise außerhalb des Bauteilebereichs angeordnet.

In einer weiteren alternativen Ausgestaltung der erfindungsgemäßen Leiterplatte weist das Foliensystem eine zusätzliche Schicht auf der Metallfolie in Form einer isolierenden Deckschicht auf und die isolierende Deckschicht ist an den Stellen, an denen die elektrische und/oder die thermische Verbindung zwischen der Strahlungsquelle/n und der Metallfolie hergestellt wird, ganz oder teilweise geöffnet. Das Öffnen dieser isolierenden Deckschicht erfolgt ebenfalls vorzugsweise mittels eines Laserverfahrens. Die isolierende Kunststoffschicht wird dabei derart entfernt, dass keine störenden Reste auf der Metallschicht zurückbleiben. Es ist alternativ möglich, die Deckschicht dicker auszubilden, so dass die Strahlungsquelle/n, vorzugsweise LEDs und/oder periphere Schaltkreise komplett oder teilweise in diese Kunststoffschicht eingebettet sind. Somit sind die Strahlungsquellen und/oder die peripheren Schaltkreise besser vor äußeren Einflüssen wie Stöße, Nässe oder Verschmutzungen geschützt.

In einer weiteren vorteilhaften Ausgestaltung der vorliegenden Erfindung besteht die isolierende Deckschicht, welche haftend auf die Metallfolie aufgebracht ist, aus einem elektrisch isolierenden Material, wobei es sich vorzugsweise um einen geeigneten Kunststoff, vorzugsweise PVB oder EVA, oder ein Kunstharz. Bei dem Kunstharz handelt es sich vorzugsweise um ein EpoxidHarz. Optional kann diese Schicht auch mit einem physikalische Gasabscheidungs (PVD)-Verfahren oder mit einem Sol-Gel Verfahren auf der Metallfolie aufgebracht werden. Diese Schicht soll die Metallschicht elektrisch von der Umgebung isolieren und eine gewisse Durchschlagsfestigkeit aufweisen. Bei Anwendungen, bei welchen das Licht zurückreflektiert werden soll ist es bevorzugt wenn diese Schicht im Bereich von 400 nm bis 1000 nm optisch transparent ist (Absorptionskoeffizient α<3*10⁻³/cm).

In einer weiteren bevorzugten Ausgestaltungsform ist die isolierende Trägerschicht und/oder die isolierende Deckschicht mittels eines Laserverfahrens geöffnet.

In einer besonders bevorzugten Ausgestaltung der flexiblen Leiterplatte besteht die Metallfolie aus Kupfer, Aluminium oder Silber, vorzugsweise aus Zinn, einer Zinnlegierung, oder einer Zinn-plattierten Kupferfolie und/oder weist eine Dicke von mehr als 5 µm, vorzugsweise 10 µm bis 100 µm, besonders bevorzugt 10 µm bis 20 µm auf.

Es ist ebenfalls erfindungsgemäß bevorzugt, wenn die Metallfolie mit einer reflektierenden Schicht beschichtet ist, wobei es sich vorzugsweise um Silber, Siliziumdioxid und/oder Titandioxid handelt. Diese Schicht ermöglicht eine besonders effiziente Reflexion des Lichts, das durch die Strahlungsquelle/n generiert wird. Diese Schicht sollte eine Reflexion von > 80% im Wellenlängenbereich von 300 nm bis 1000 nm aufweisen.

In einer weiteren vorteilhaften Ausgestaltung ist die Metallfolie mit einer Oberflächentextur versehen. Diese stellt sicher, dass das Licht diffus zurückreflektiert wird. Die Oberflächentextur besteht vorzugsweise aus dreidimensionalen, regelmäßigen oder unregelmäßigen Strukturen. Besonders bevorzugt besteht die Oberflächentextur der Metallfolie aus Pyramiden oder Halbkugeln, die eine charakteristische Größe von höchstens 1000 nm aufweisen. Es ist von Vorteil, wenn die Oberflächentextur und/oder die Pyramiden oder Halbkugeln eine zufällige Höhenverteilung von 10-1000 nm, vorzugsweise 100-1000 nm aufweisen.

Die Strahlungsquelle umfasst erfindungsgemäß mindestens eine Leuchtdiode oder mindestens eine Gruppe von Leuchtdioden. Die Strahlungsquelle kann beispielsweise als LED-Modul mit einer oder mehreren Leuchtdioden oder als LED-Chip vorliegen. Die einzelnen LEDs können jeweils einfarbig oder mehrfarbig abstrahlen. Es kann auch eine IR-Licht abstrahlende LED verwendet werden.

Ein Beleuchtungsmodul, das eine erfindungsgemäße flexible Leiterplatte aufweist, ist ebenfalls Bestandteil der Erfindung. Die flexible Leiterplatte ist auf ein Substrat mit beliebiger dreidimensionaler Struktur, welches gleichzeitig die Wärmesenke darstellt, aufgebracht.

Weiterhin ist ein Verfahren zur Herstellung eines erfindungsgemäßen Beleuchtungsmoduls ein Bestandteil der Erfindung. Dieses Herstellungsverfahren beinhaltet die folgenden Verfahrensschritte:
- Verbinden einer Metallfolie mit einer isolierenden Trägerschicht mittels einer haftenden Verbindung,
- Öffnen der Trägerschicht an den Stellen, an denen thermische Verbindungen zwischen einer Wärmesenke und der Metallfolie bewerkstelligt werden,
- Aufbringen eines thermisch leitenden Klebers oder Lot auf die Stellen, an denen thermische Verbindungen zwischen der Wärmesenke und der Metallfolie oder zwischen der Wärmesenke und der LED bewerkstelligt werden,
- Aufbringen einer oder mehrerer LED(s) auf die Metallfolie, vorzugsweise mittels Lot,
- Auflaminieren des Foliensystems auf ein Substrat, das gleichzeitig die Wärmesenke darstellt.

Es ist besonders bevorzugt, wenn ein oder mehrere LEDs auf ein strukturiertes, bereits auf Format geschnittenes Foliensystem aufgebracht werden. Die LEDs werden vorzugsweise mittels eines Reflow-Lötprozesses mit dem Leiter verlötet. Dies erfolgt auch an den Stellen des Wärmekontaktes, wobei dort auch ein thermisch leitender Kleber verwendet werden kann.

In einer weiteren vorteilhaften Ausgestaltung des erfindungsgemäßen Verfahrens ist das Verfahren dadurch gekennzeichnet, dass
- die Metallfolie in getrennte Abschnitte unterteilt ist, wobei mindestens ein Abschnitt eine elektrische Verbindung zu den LEDs ausbildet und mindestens ein weiterer Abschnitt eine elektrisch isolierte und/oder thermische Verbindung zur Strahlungsquelle und zur Wärmesenke ausbildet, und/oder
- die Trägerschicht nach der Lamination haftend mit der Struktur verbunden ist, die als Wärmesenke dient und eine beliebige dreidimensionale Form einnimmt, und/oder
- auf der Metallfolie eine zusätzliche Schicht in Form einer isolierenden Deckschicht aufgebracht ist, die an den Stellen, an denen die elektrische und/oder thermische Verbindung zwischen der Strahlungsquelle/n und der Metallfolie hergestellt wird, ganz oder teilweise geöffnet ist und auf der die LEDs haften, und/oder
- die Metallfolie und/oder die Plastikfolien mittels Laserablation strukturiert werden, und/oder
- die Metallfolie vor oder nach dem Verbinden mit der isolierenden Trägerschicht durch eine haftende Verbindung vorzugsweise mittels Laserablation strukturiert wird.

Das erfindungsgemäße Verfahren hat den Vorteil, dass während des Laminationsprozesses bereits die mechanischen, thermischen und elektrischen Verbindungen in einem Verfahrensschritt entstehen können. Die Eigenschaften des erfindungsgemäßen Foliensystems können auf die jeweiligen Bedürfnisse jederzeit angepasst werden. Dadurch, dass das Foliensystem mechanisch sehr flexibel ist, kann es für eine Vielzahl von LED-Anwendungen eingesetzt werden. Hierbei sind an dreidimensionalen Strukturen keine Grenzen gesetzt. Das Foliensystem ist ebenfalls für dauerhaft beanspruchte Verbindungen geeignet.

Der Laserablations-Prozess, der vorzugsweise für die Strukturierung der Metallfolie und die Kunststofffolien eingesetzt wird, ist extrem präzise, so dass hohe Packungsdichten erreicht werden können. Das Foliensystem kann außerdem in Massen produziert werden, beispielsweise mittels *roll-to-roll* (R2R) -Laminationsprozessen. Selektive Laserablations-Prozesse ermöglichen das Öffnen der Bereiche, an denen thermische und/oder elektrische Verbindungen hergestellt werden und erlauben gleichzeitig die Herstellung von elektrischen und/oder thermischen Verbindungen. Mittels Stempel-Prozessen kann das Foliensystem in jeder beliebigen Form hergestellt werden, alternativ können R2R-Montageprozesse verwendet werden. Alle Verfahrensschritte können in eine einzige Produktionslinie integriert werden, so dass große Mengen in kürzester Zeit produziert werden können.

Ebenfalls Bestandteil der Erfindung ist die Verwendung eines Foliensystems bestehend aus einer isolierenden Trägerschicht, einer Metallfolie und/oder einer isolierenden Deckschicht zur Verschaltung und zum Anschluss von LEDs sowie zum Abführen der entstehenden Wärme in Beleuchtungsmodulen.

Im Folgenden soll die Erfindung anhand von Zeichnungen näher erläutert werden, wobei sich die Erfindung selbstverständlich nicht auf die dargestellten Ausgestaltungen beschränkt. Dabei zeigen:

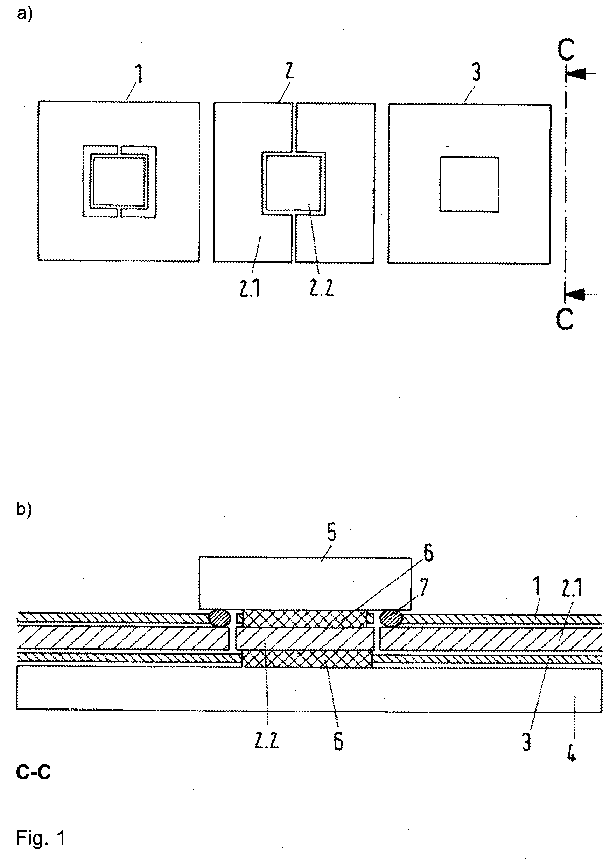

- Fig. 1:: ein erfindungsgemäßes Beleuchtungsmodul mit einer LED, bei dem ein Teil der Metallfolie für die Wärmeableitung genutzt wird, wobei in Teilabbildung a) die einzelnen Schichten des Foliensystems in Draufsicht schematisch dargestellt sind und in der Teilabbildung b) ein Querschnitt durch das Beleuchtungsmodul gezeigt ist;

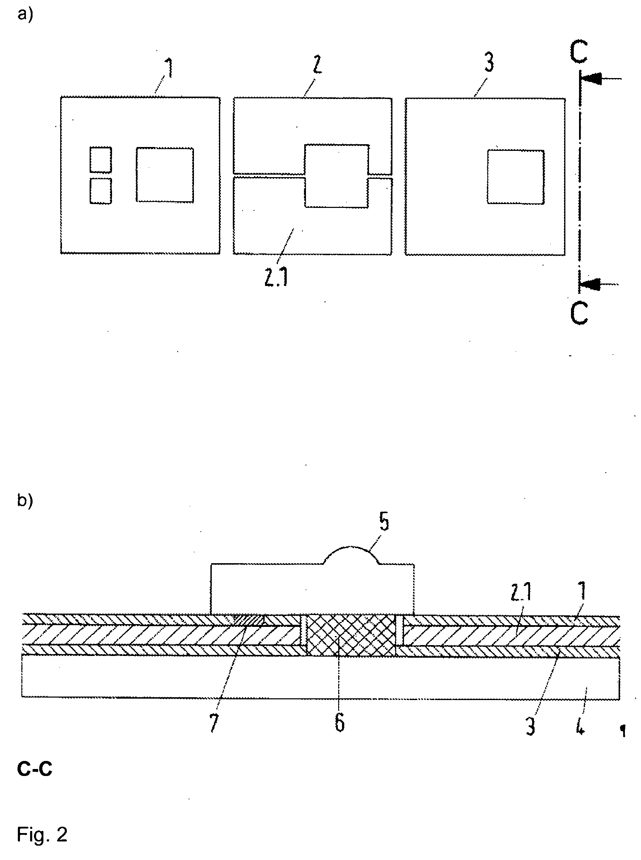

- Fig. 2:: ein Beleuchtungsmodul mit einer LED, bei dem ein elektrisch leitender Kleber für die Wärmeableitung genutzt wird, wobei in Teilabbildung a) die einzelnen Schichten des Foliensystems in Draufsicht schematisch dargestellt sind und in der Teilabbildung b) ein Querschnitt durch das Beleuchtungsmodul gezeigt ist.

In Fig. 1 ist ein erfindungsgemäßes Beleuchtungsmodul mit einer LED dargestellt, wobei ein Teil der Metallfolie 2.2 für die Wärmeableitung genutzt wird. In der Teilabbildung a) sind die einzelnen Schichten des Foliensystems in Draufsicht schematisch dargestellt. Die isolierende Trägerschicht 3 ist an den Stellen, an denen thermische Kontakte zwischen der Strahlungsquelle und der Metallfolie, beziehungsweise zwischen der Metallfolie und der Wärmesenke hergestellt werden aufgetrennt. Als Strahlungsquelle 5 wird in diesem Fall ein LED-submount eingesetzt. Die Metallfolie 2 ist in räumlich voneinander getrennte Abschnitte unterteilt, wobei ein Abschnitt 2.2 für die Wärmeableitung von der Strahlungsquelle zur Wärmesenke genutzt wird und der andere Abschnitt 2.1 eine elektrische Verbindung zur Strahlungsquelle ausbildet. Zum Abschluss des Moduls ist eine isolierende Deckschicht 1 auf der Metallfolie aufgebracht, welche ebenfalls an den Stellen, an denen thermische und/oder elektrische Kontakte zur Metallfolie ausgebildet werden, aufgetrennt ist. In der Teilabbildung b) ist ein Querschnitt durch das Beleuchtungsmodul schematisch dargestellt, wobei ein Abschnitt der Metallfolie 2.2 mittels eines thermisch leitenden Klebers oder Lot 6 eine thermische Verbindung zwischen der Strahlungsquelle 5 und der Wärmesenke 4 ausbildet, damit die von der Strahlungsquelle 5 produzierte Wärme effizient abgeführt werden kann. Für die elektrische Verschaltung wird ein elektrisch leitender Kleber oder Lot 7 eingesetzt, der eine Verbindung zwischen der Strahlungsquelle 5 und dem anderen Abschnitt der Metallfolie 2.1 ausbildet.

In Fig. 2 ist eine Ausgestaltungsform eines Beleuchtungsmoduls mit einer LED dargestellt, wobei ein thermisch leitender Kleber oder Lot 6 eine thermische Verbindung direkt zwischen der Strahlungsquelle (LED-submount) 5 und der Wärmesenke 4 ausbildet. Somit wird die von der Strahlungsquelle 5 produzierte Wärme direkt über den thermisch leitenden Kleber oder das Lot 6 in die Wärmesenke abgeleitet. Das Foliensystem besteht auch bei diesem Beleuchtungsmodul aus einer isolierenden Trägerschicht 3, einer Metallfolie 2, und einer isolierenden Deckschicht 1. In diesem Fall ist die Metallfolie ebenfalls aufgetrennt, wobei jedoch kein Abschnitt für die Herstellung einer thermischen Verbindung ausgenutzt wird. Hingegen wird die Metallfolie 2 als elektrischer Leiter 2.1 verwendet und es wird mittels eines elektrisch leitenden Klebers oder Lot 7 eine elektrische Verbindung zwischen der Strahlungsquelle 5 und dem Leiter 2.1 hergestellt.

### Bezugszeichenliste:

- 1: isolierende Deckschicht
- 2: Metallfolie
- 2.1: Abschnitt der Metallfolie, der eine elektrische Verbindung zur Strahlungsquelle ausbildet
- 2.2: Abschnitt der Metallfolie, der eine elektrisch isolierte und/oder thermische Verbindung zur Strahlungsquelle und zur Wärmesenke ausbildet
- 3: isolierende Trägerschicht
- 4: Wärmesenke
- 5: Strahlungsquelle
- 6: thermisch leitender Kleber oder Lot
- 7: elektrisch leitender Kleber oder Lot

## Patentansprüche

1. Flexible Leiterplatte, auf welche mindestens eine Strahlungsquelle (5) aufgebracht ist, bestehend aus einem Foliensystem, wobei
- die Strahlungsquelle (5) mehrere Leuchtdioden (LEDs) umfasst und
- die flexible Leiterplatte eine thermische Verbindung zu einer Wärmesenke aufweist und das Foliensystem mindestens aus den folgenden Schichten zusammengesetzt ist:
- einer isolierende Trägerschicht (3), die an den Stellen, an denen die thermische Verbindung mit der Wärmesenke hergestellt wird (6), geöffnet ist und
- einer Metallfolie (2), die in unterschiedliche Abschnitte unterteilt ist (2.1, 2.2),
**dadurch gekennzeichnet, dass**
die thermische Verbindung zwischen räumlich getrennten Abschnitten der Metallfolie (2.2) und der Wärmesenke (4) und zwischen räumlich getrennten Abschnitten der Metallfolie (2.2) und der Strahlungsquelle (5) ausgebildet wird,
und die Metallfolie (2) in voneinander räumlich getrennte Abschnitte unterteilt ist (2.1, 2.2),
- wobei mindestens ein Abschnitt (2.1) eine elektrische Verbindung (7) zur Strahlungsquelle/n ausbildet und mindestens ein weiterer Abschnitt (2.2) eine elektrisch isolierte und/oder thermische Verbindung (6) zur Strahlungsquelle und zur Wärmesenke ausbildet und
- ein Teil der Metallfolie (2.1) als elektrischen Leiter benutzt wird und ein davon räumlich abgetrennten Abschnitt (2.2) für die Wärmeableitung von der Strahlungsquelle zur Wärmesenke verwendet wird.

2. Flexible Leiterplatte nach Anspruch 1, **dadurch gekennzeichnet, dass** die thermische Verbindung (6) mittels eines thermisch leitenden Klebers oder Lot und die elektrisch leitende Verbindung (7) mittels eines elektrisch leitenden Klebers oder Lot hergestellt werden.

3. Flexible Leiterplatte nach einem der vorherigen Ansprüche, **dadurch gekennzeichnet, dass**
- das Foliensystem eine zusätzliche Schicht auf der Metallfolie in Form einer isolierenden Deckschicht (1) aufweist und
- die isolierende Deckschicht an den Stellen, an denen die elektrische (7) und/oder die thermische Verbindung (6) zwischen der Strahlungsquelle/n und der Metallfolie hergestellt wird, ganz oder teilweise geöffnet ist, und/oder
- die Strahlungsquelle/n (5) und/oder peripheren Schaltkreise in die isolierende Deckschicht (1) teilweise oder ganz eingebettet sind.

4. Flexible Leiterplatte nach einem der vorherigen Ansprüche, **dadurch gekennzeichnet, dass** die Metallfolie (2)
- aus Kupfer, Aluminium oder Silber, vorzugsweise aus Zinn, einer Zinnlegierung, oder einer Zinn-plattierten Kupferfolie besteht, und/oder
- eine Dicke von mehr als 5 µm, vorzugsweise 10 µm bis 100 µm, besonders bevorzugt 10 µm bis 20 µm aufweist, und/oder
- mit einer reflektierenden Schicht beschichtet ist, wobei es sich vorzugsweise um Silber, Siliziumdioxid und/oder Titandioxid handelt, und/oder
- mit einer Oberflächentextur versehen ist, die vorzugsweise aus dreidimensionalen, regelmäßigen oder unregelmäßigen Strukturen, besonders bevorzugt aus Pyramiden oder Halbkugeln besteht, und/oder
- eine Leiterbahnstruktur ausbildet, welche vorzugsweise mittels Laser strukturiert wird.

5. Flexible Leiterplatte nach einem der vorherigen Ansprüche, **dadurch gekennzeichnet, dass** die Strahlungsquelle (5) mindestens eine Gruppe von Leuchtdioden (LEDs) umfasst.

6. Beleuchtungsmodul, **dadurch gekennzeichnet, dass** es eine flexible Leiterplatte nach Anspruch 5 aufweist, die auf ein Substrat mit beliebiger dreidimensionaler Struktur, welches gleichzeitig die Wärmesenke (4) darstellt, aufgebracht ist.

7. Verfahren zur Herstellung eines Beleuchtungsmoduls nach Anspruch 6 beinhaltend folgende Verfahrensschritte:
- Verbinden einer Metallfolie (2) mit einer isolierenden Trägerschicht (3) mittels einer haftenden Verbindung,
- Öffnen der Trägerschicht (3) an den Stellen, an denen thermische Verbindungen (6) zwischen einer Wärmesenke (4) und der Metallfolie (2) bewerkstelligt werden,
- Aufbringen eines thermisch leitenden Klebers oder Lot auf die Stellen, an denen thermische Verbindungen (6) zwischen der Wärmesenke (4) und der Metallfolie (2) oder zwischen der Wärmesenke (4) und der LED (5) bewerkstelligt werden,
- Aufbringen mehrerer LED(s) (5) auf die Metallfolie (2), vorzugsweise mittels Lot,
- Auflaminieren des Foliensystems auf ein Substrat, das gleichzeitig die Wärmesenke (4) darstellt.

8. Verfahren zur Herstellung eines LED-Moduls nach Anspruch 7, **dadurch gekennzeichnet, dass** die isolierende Trägerschicht (3) und/oder die isolierende Deckschicht (1) mittels eines Laserverfahrens geöffnet werden.

9. Verfahren zur Herstellung eines LED-Moduls nach Anspruch 7 oder 8, **dadurch gekennzeichnet, dass**
- die Metallfolie (2) in getrennte Abschnitte (2.1, 2.2) unterteilt ist, wobei mindestens ein Abschnitt (2.1) eine elektrische Verbindung zu den LEDs ausbildet und mindestens ein weiterer Abschnitt (2.2) eine elektrisch isolierte und/oder thermische Verbindung zur Strahlungsquelle (5) und zur Wärmesenke (4) ausbildet, und/oder
- die Trägerschicht (3) nach der Lamination haftend mit der Struktur verbunden ist, die als Wärmesenke (4) dient und eine beliebige dreidimensionale Form einnimmt, und/oder
- auf der Metallfolie (2) eine zusätzliche Schicht in Form einer isolierenden Deckschicht (1) aufgebracht ist, die an den Stellen, an denen die elektrische (7) und/oder thermische (6) Verbindung zwischen der Strahlungsquelle/n (5) und der Metallfolie (2) hergestellt wird, ganz oder teilweise geöffnet ist und auf der die LEDs haften, und/oder
- die Metallfolie (2) und/oder die Plastikfolien (1,3) mittels Laserablation strukturiert werden, und/oder
- die Metallfolie (2) vor oder nach dem Verbinden mit der isolierenden Trägerschicht (3) durch eine haftende Verbindung vorzugsweise mittels Laserablation strukturiert wird.

10. Verwendung einer flexiblen Leiterplatte nach einem der Ansprüche 1 bis 5 zur Verschaltung und zum Anschluss von LEDs (5) sowie zum Abführen der entstehenden Wärme in Beleuchtungsmodulen.

## Claims

1. Flexible circuit board on which at least one radiation source (5) is applied, consisting of a foil system wherein
- the radiation source (5) comprises a plurality of light emitting diodes (LEDs) and
- the flexible printed circuit board has a thermal connection to a heat sink and the foil system is composed of at least the following layers:
- an insulating support layer (3) which is opened at the points where the thermal connection is made with the heat sink (6) and
- a metal foil (2), which is divided into different sections (2.1, 2.2),
**characterized in that**
the thermal connection between the spatially separated sections of the metal foil (2.2) and the heat sink (4) and between distinct sections of the metal foil (2.2) and the radiation source (5) is formed,
and the metal foil (2) is divided into spatially separated sections (2.1, 2.2),
- wherein at least one section (2.1) forms an electrical connection (7) to the radiation source and at least one further section (2.2) forms an electrically insulated and / or thermal connection (6) to the radiation source and the heat sink and
- one section of the metal foil (2.1) is used as an electrical conductor and a spatially separated section (2.2) is used for the heat dissipation from the radiation source to the heat sink.

2. A flexible circuit board according to claim 1, **characterized in that** the thermal connection (6) is provided by means of a thermally conductive adhesive or solder and the electrically conductive connection (7) is formed by means of an electrically conductive adhesive or solder.

3. A flexible circuit board according to any one of the preceding claims, **characterized in that**
- the system comprises an additional foil layer on the metal foil built as an insulating cover layer (1) and
- the insulating cover layer is opened completely or partially at the points where the electrical (7) and / or the thermal connection (6) between the radiation source and the metal foil is built, and / or
- the radiation source (5) and / or peripheral circuits are partially or entirely embedded in the insulating cover layer (1).

4. A flexible circuit board according to any one of the preceding claims, **characterized in that** the metal foil (2)
- consists of copper, aluminum or silver, preferably of tin, a tin alloy, or a tin plated copper foil, and / or
- has a thickness of more than 5 µm, preferably 10 µm to 100 µm, particularly preferably from 10 µm to 20 µm, and / or
- is coated with a reflective layer, which preferably consists of silver, silicon dioxide and / or titanium dioxide, and / or
- is provided with a surface texture which preferably is composed of three-dimensional, regular or irregular structures of pyramids or hemispheres, and / or
- a conductor structure is formed, which is preferably structured by means of laser.

5. A flexible circuit board according to any one of the preceding claims, **characterized in that** the radiation source (5) comprises at least one group of light emitting diodes (LEDs).

6. An illumination module, **characterized in that** it comprises a flexible circuit board according to claim 5, which is applied to a substrate with an arbitrary three-dimensional structure, which at the same time builds the heat sink (4).

7. A method for preparing an illumination module according to claim 6 comprising the following method steps:
- bonding a metal foil (2) with an insulating carrier layer (3) by means of an adhesive compound,
- opening the carrier layer (3) at the points at which thermal connections (6) between the heat sink (4) and the metal foil (2) are provided
- applying a thermally conductive adhesive or solder at the points where thermal connections (6) between the heat sink (4) and the metal foil (2) or between the heat sink (4) and the LED (5) are provided
- applying a plurality of LED (s) (5) to the metal foil (2), preferably by means of solder,
- laminating the film system on a substrate that is simultaneously the heat sink (4).

8. A process for the preparation of an LED module according to claim 7, **characterized in that** the insulating supporting layer (3) and / or the insulating cover layer (1) are opened by means of a laser process.

9. A process for the production of an LED module according to claim 7 or 8, **characterized in that**
- the metal film (2) is divided into separate sections (2.1, 2.2), wherein at least one section (2.1) forms an electrical connection to the LEDs and at least one further section (2.2) forms an electrically insulated and / or thermal connection to the radiation source (5) and to the heat sink (4), and / or
- after the lamination the support layer (3) is adhered to the structure that serves as a heat sink (4) and builds any three-dimensional shape, and / or
- an additional layer as insulating cover layer (1) is applied to the metal foil (2) and which is opened completely or partly at the points at which the electrical (7) and / or thermal (6) connection between the radiation source/s (5) and the metal foil (2) is built, and on which the LEDs are attached, and / or
- the metal foil (2) and / or the plastic sheets (1,3) are structured by means of laser ablation, and / or
- the metal foil (2) is patterned before or after bonding to the insulating support layer (3) by an adhesive connection, preferably by means of laser ablation.

10. Use of a flexible printed circuit board according to any one of claims 1 to 5 for the interconnection and connection of LEDs (5) as well as for dissipating the heat generated in lighting modules.

## Revendications

1. Carte imprimée souple sur laquelle au moins une source de rayonnement (5) est appliqué, constitué d'un système de feuille, dans lequel
- la source de rayonnement (5) comprend une pluralité de diodes électroluminescentes (DEL) et
- la carte imprimé souple a une connexion thermique à un dissipateur de chaleur et le système de feuille est composée d'au moins les couches suivantes:
- une couche de support isolante (3) qui est ouverte aux endroits où la connexion thermique est faite avec le dissipateur thermique (6) et
- une feuille métallique (2), qui est divisé en différentes sections (2.1, 2.2),
**caractérisé en ce que**
la connexion thermique est formée entre des sections séparées de la feuille métallique (2,2) et le dissipateur de chaleur (4) et entre des sections séparées de la feuille métallique (2,2) et la source de rayonnement (5),
et la feuille métallique (2) est divisé en sections séparées (2.1, 2.2),
- dans lequel au moins une section (2.1) forme une connexion électrique (7) à la source de rayonnement et au moins une autre section (2.2) forme une connexion isolée et / ou thermique (6) à la source de rayonnement et au dissipateur thermique et
- une section de la feuille métallique (2,1) est utilisée comme un conducteur électrique et une section spatialement séparé (2,2) est utilisé pour la dissipation de chaleur de la source de rayonnement vers le dissipateur thermique.

2. Carte imprimée souple selon la revendication 1, **caractérisé en ce que** la connexion thermique (6) est produite au moyen d'un adhésif conducteur thermique ou de la soudure et que la connexion électrique (7) est produite au moyen d'un adhésif conducteur ou de la soudure.

3. Carte imprimée souple selon l'une quelconque des revendications précédentes, **caractérisé en ce que**
- le système comprend une couche de film supplémentaire sur la feuille métallique sous la forme d'une couche de recouvrement isolante (1) et
- la couche de recouvrement isolante est ouverte complètement ou partiellement aux endroits où la connexion électrique (7) et / ou la connexion thermique (6) entre la source de rayonnement et la feuille métallique est produit, et / ou
- la source de rayonnement (5) et / ou des circuits périphériques sont encastrés dans la couche isolante (1) partiellement ou entièrement.

4. Carte imprimée souple selon l'une quelconque des revendications précédentes, **caractérisé en ce que,** la feuille métallique (2)
- est composé de cuivre, d'aluminium ou d'argent, de préférence d'étain, un alliage d'étain, ou une feuille de cuivre plaqué d'étain, et / ou
- a une épaisseur de plus de 5 µm, de préférence de 10 µm à 100 µm, de manière particulièrement préférée de 10 µm à 20 µm, et / ou
- est revêtue d'une couche réfléchissante, de préférence constitué d'argent, de dioxyde de silicium et / ou dioxyde de titane, et / ou
- est munie d'une texture de surface qui est de préférence constitué de structures à trois dimensions régulières ou irrégulières, de préférence de pyramides ou hémisphères, et / ou
- forme une structure de conducteur, qui est de préférence structuré par laser.

5. Carte imprimée souple selon l'une quelconque des revendications précédentes, **caractérisé en ce que** la source de rayonnement (5) comprend au moins un groupe de diodes électroluminescentes (DEL).

6. Un module d'éclairage, **caractérisé en ce qu**'il comprend une carte imprimée souple selon la revendication 5, qui est appliquée sur un substrat avec une structure à trois dimensions arbitraire, qui en même temps représente le dissipateur thermique (4).

7. Procédé de préparation d'un module d'éclairage selon la revendication 6, comprenant les étapes de procédé suivantes:
- accoler une feuille métallique (2) à une couche de support isolante (3) au moyen d'un composé adhésif,
- ouvrir la couche de support (3) aux positions où les connexions thermiques (6) entre un dissipateur thermique (4) et la feuille métallique (2) peuvent être accomplies,
- appliquer un adhésif ou de la soudure conductrice sur les sections, qui produisent des connexions thermiques (6) entre le dissipateur thermique (4) et la feuille métallique (2) ou entre le dissipateur thermique (4) et la DEL (5),
- appliquer une pluralité de DELs (5) sur la feuille métallique (2), de préférence au moyen de soudure,
- laminer le système de feuille sur un substrat qui est en même temps le dissipateur thermique (4).

8. Un procédé de préparation d'un module DEL selon la revendication 7, **caractérisé en ce que** la couche isolante de support (3) et / ou la couche de couverture isolante (1) sont ouvert au moyen d'un procédé laser.

9. Un procédé de préparation d'un module DEL selon la revendication 7 ou 8, **caractérisé en ce que**
- la feuille métallique (2) est divisé en sections séparées (2.1, 2.2), dans lequel au moins une section (2.1) forme une connexion électrique avec les DELs et au moins une autre section (2.2) forme une connexion isolée et / ou thermique à la source de rayonnement (5) et au dissipateur thermique (4), et / ou
- la couche de support (3) est collée à la structure qui sert de dissipateur thermique (4) après le laminage et prend une forme quelconque à trois dimensions, et / ou
- sur la feuille métallique (2) une couche supplémentaire sous la forme d'une couche de recouvrement isolante (1) est appliquée, qui est ouvert complètement ou partiellement aux positions où la connexion électrique (7) et / ou thermique (6) entre la source de rayonnement (5) et la feuille métallique (2) est produit, et sur laquelle les DELs s'attachent, et/ou
- la feuille métallique (2) et / ou les feuilles de plastique (1,3) sont structurées au moyen d'une ablation au laser, et / ou
- la feuille métallique (2) est structurée de préférence au moyen d'une ablation au laser, avant ou après le collage de la couche de support isolante (3) par une liaison collage.

10. Utilisation d'une carte imprimée souple selon une quelconque des revendications 1 à 5 pour la connexion et l'interconnexion de DELs (5) ainsi que pour dissiper la chaleur générée dans les modules d'éclairage.
